# EUROPÄISCHE PATENTSCHRIFT

(11) **EP 1 116 328 B1**
(45) Veröffentlichungstag und Bekanntmachung des Hinweises auf die Patenterteilung: **05.03.2003**
(21) Anmeldenummer: 99939359.8
(22) Anmeldetag: 17.06.1999
(51) Int. Cl.: H03K 17/955

(54) **MESSSCHALTUNG FUER EINEN KAPAZITIVEN SENSOR**
MEASURING CIRCUIT FOR A CAPACITIVE SENSOR
CIRCUIT DE MESURE POUR CAPTEUR CAPACITIF

(30) Priorität: 10.08.1998 DE 19836054
(43) Veröffentlichungstag der Anmeldung: 18.07.2001
(73) Patentinhaber: ROBERT BOSCH GMBH, 70442 Stuttgart (DE)
(72) Erfinder: WEBER, Jens, D-65779 Kelkheim-Fischbach (DE); HOETZEL, Juergen, D-61197 Florstadt (DE); RECH, Wolf-Henning, D-71229 Leonberg (DE); TSCHISKALE, Ega, D-78333 Hoppetenzell (DE)
(86) Internationale Anmeldenummer: DE9901780
(87) Internationale Veröffentlichungsnummer: WO00010250

(56) Entgegenhaltungen:
- WO-A-89/08352
- DE-A- 2 044 790
- DE-A- 19 501 642
- US-A- 5 757 196

## Beschreibung

Die Erfindung betrifft eine Meßschaltung für einen aus Sensordraht und Abschirmelektrode bestehenden kapazitiven Sensor zur Abstandsmessung und/oder Raumüberwachung.

Kapazitive Sensoren haben sich in letzter Zeit bei der Raumüberwachung und auch bei der Messung des Abstandes von Hindernissen, beispielsweise im Nahbereich von Kraftfahrzeugen, vielfach bewährt. Bei einem aus DE 195 01 642 A1 bekannten Verfahren zur berührungslosen Abstandsmessung, welches als sogenannte Einparkhilfe dient, sind Ultraschall-Sensoren und auch ein kapazitiver Sensor eingesetzt, dessen Meßschaltung jedoch für höhere Anforderungen an die Genauigkeit oft nicht ausreichend ist.

Der vorliegenden Erfindung liegt daher die Aufgabe zugrunde, eine Meßschaltung der eingangs genannten Art anzugeben, mit welcher eine empfindliche und hochauflösende Eingangsstrom- und damit Kapazitätsmessung möglich ist.

Diese Aufgabe wird erfindungsgemäß dadurch gelöst, daß die Abschirmelektrode mit einem Sinussignal beaufschlagt ist, daß der Sensordraht über ein abgeschirmtes Kabel mit dem einen Eingang eines als Strom-Spannungs-Wandler dienenden Eingangsverstärkers verbunden ist, dessen Versorgungsspannung ebenfalls vom Sinussignal beeinflußt ist, daß der Ausgang des Eingangsverstärkers mit dem einen Eingang einer phasenabhängigen Gleichrichteranordnung verbunden ist, an deren anderem Eingang das Sinussignal anliegt und deren Ausgang an einen Analog/Digital-Wandler angeschlossen ist.

Die erfindungsgemäße Meßschaltung hat den Vorteil, daß sie bei einem geringen Aufwand an Bauteilen temperaturunempfindlich ist, eine extrem niedrige Eingangskapazität (< 10 fF) hat und eine Meßgeschwindigkeit unter 100 µs aufweist. Ein weiterer Vorteil ist darin zu sehen, daß diese Meßschaltung kraftfahrzeugtauglich ist, da sie insbesondere im Langwellen-Bereich von Autoradios nicht stört.

Eine vorteilhafte Ausbildung der erfindungsgemäßen Meßschaltung besteht darin, daß der Eingangsverstärker ein gegengekoppelter Differenzverstärker für einen kapazitiv induzierten Differenzstrom ist, dessen invertierender Eingang mit dem Sensordraht verbunden ist und dessen nicht invertierender Eingang an einen zwischen einer Konstantspannungsquelle und der Sinussignalquelle geschalteten Spannungsteiler angeschlossen ist, wobei der mit der Sinussignalquelle verbundene Widerstand des Spannungsteilers mit einem Kondensator überbrückt ist.

Wegen der Gegenkopplung und des daraus resultierenden niedrigen Eingangswiderstands beeinträchtigen die Eingangs- und Koppelkapazitäten die Empfindlichkeit kaum. Außerdem wird die wirksame Eingangskapazität durch die Gegenkopplung um den Betrag der Leerlaufspannungsverstärkung des Verstärkers reduziert. Somit können Kapazitätsänderungen der Umgebung sicher detektiert werden, die um mehrere Größenordnungen unter der Eingangskapazität der Schaltung liegen.

Dabei hat sich besonders bewährt, daß als Differenzverstärker ein Operationsverstärker eingesetzt ist, dessen Versorgungsspannung durch einen Spannungsregler relativ zur Spannung der Abschirmelektrode stabilisiert ist. Dadurch wird vermieden, daß dessen begrenzte Unterdrückung von Signalen auf der Versorgungsspannung ein Eingangssignal vortäuscht. Damit kann die volle Empfindlichkeit ausgenutzt werden.

Zur Vermeidung von Störungen hat es sich als vorteilhaft erwiesen, daß die Abschirmelektrode des Sensors über die Abschirmung des abgeschirmten Kabels mit der Sinussignalquelle verbunden ist. Dadurch treten nur sehr geringe Verzerrungen auf, so daß die EMV-Anforderungen erfüllt werden können.

Bei einer besonders vorteilhaften Ausbildung der Erfindung wird vorgeschlagen, daß zwischen Eingangsverstärker und phasenabhängiger Gleichrichteranordnung eine Subtrahierstufe vorgesehen ist, deren positiver Eingang mit dem Ausgang des Eingangsverstärkers verbunden ist und deren negativer Eingang mit dem Sinussignal beaufschlagt ist. Mit der Subtrahierstufe wird der konstante, von der modulierten Versorgungsspannung stammende Signalanteil am Ausgang des Eingangsverstärkers entfernt.

Bei einer weiteren vorteilhaften Ausführung der Erfindung wird vorgeschlagen, daß am Ausgang der Subtrahierstufe ein Filter vorgesehen ist, welches zur Vorfilterung für die nachfolgende Stufe, das heißt für die phasenabhängige Gleichrichteranordnung, dient.

Ausführungsbeispiele der Erfindung sind in der Zeichnung anhand mehrerer Figuren dargestellt und in der nachfolgenden Beschreibung näher erläutert. Es zeigt:
- Fig. 1: ein Blockschaltbild einer erfindungsgemäßen Meßschaltung,
- Fig. 2: eine Ausführung eines Eingangsverstärkers der Meßschaltung.

Gleiche Teile sind in den Figuren mit gleichen Bezugszeichen versehen.

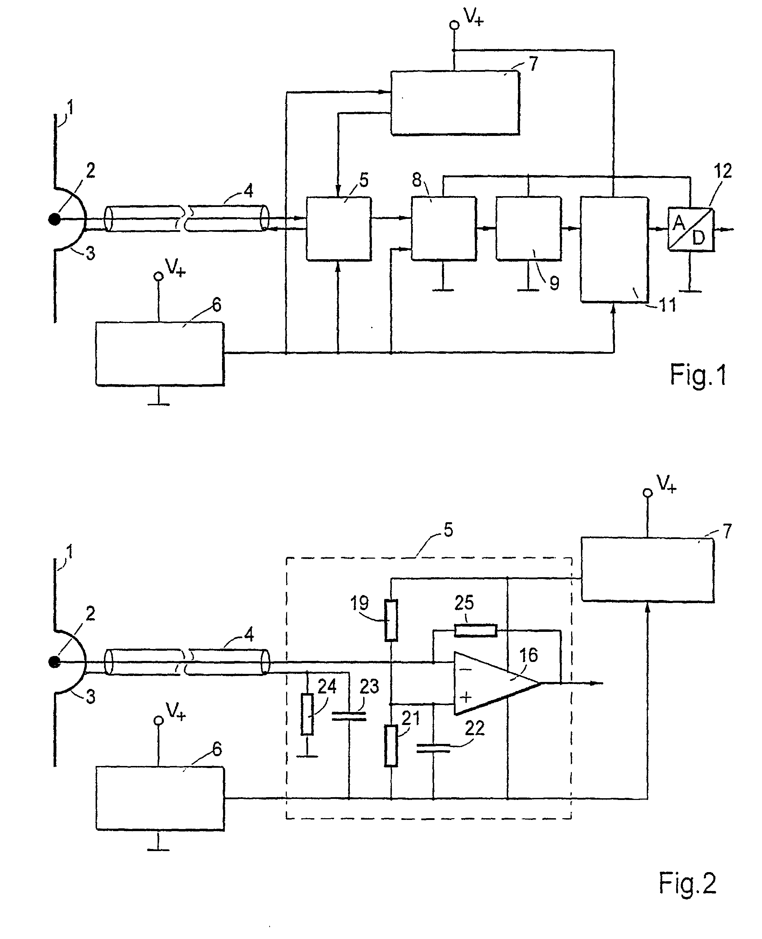

In Fig. 1 ist ein kapazitiver Sensor 1, bestehend aus einem Sensordraht 2 und einer Abschirmelektrode 3, dargestellt, welche über den Innenleiter bzw. die Abschirmung eines Kabels 4 mit der erfindungsgemäßen Meßschaltung verbunden sind. Der Innenleiter des Kabels 4 ist direkt an einen Eingang eines Eingangsverstärkers 5 angeschlossen, an dessen anderem Eingang ein von einer Sinussignalquelle 6 (mit Gleichspannungs-Offset) erzeugtes Sinussignal anliegt, welches weiterhin der Abschirmung des Kabels 4 zugeführt wird. Außerdem wird der Eingangsverstärker 5 von einer Konstantspannungsquelle 7, welcher ebenfalls das Sinussignal zugeführt wird, mit einer dadurch entsprechend modulierten Versorgungsspannung gespeist. Hierdurch ist eine extrem niedrige Eingangskapazität im Femto-Farad-Bereich möglich. Der zur Strom/Spannungswandlung dienende Eingangsverstärker 5, welcher anhand von Fig. 2 noch näher beschrieben wird, gibt an seinem Ausgang ein entsprechend der Kapazitätsgröße bzw. -änderung erzeugtes Meßsignal ab, wobei konzeptbedingt nur der Signalanteil, der über den Sinussignalanteil hinausgeht, der gemessenen Kapazität des Sensors 1 zuzuordnen ist.

Dieses Meßsignal wird dann einem Eingang einer Subtrahierstufe 8 zugeführt, an deren anderem Eingang ebenfalls das Sinussignal anliegt. Hiermit wird der konstante, von der modulierten Versorgungsspannung stammende Signalanteil am Ausgang des Eingangsverstärkers 5 entfernt.

Das Ausgangssignal der Subtrahierstufe 8 wird gegebenenfalls einem Filter 9 zur Vorfilterung einer phasenabhängigen Gleichrichteranordnung 11 zugeführt, an welcher auch das Sinussignal anliegt. Hierbei wird das Sinussignal zunächst in seiner Phase der des Meßsignals angepaßt und danach mit dem Meßsignal so weiterverarbeitet, daß am Ausgang der phasenabhängigen Gleichrichteranordnung 11 ein entsprechendes Gleichspannungssignal abnehmbar ist.

Eine temperaturabhängige Frequenzdrift der Sinussignalquelle 6, die sich stets auf das Meßsignal auswirkt, kann an sich nur durch aufwendige und damit teure Schaltungen reduziert werden. Mit der hier eingesetzten phasenabhängigen Gleichrichteranordnung 11 sind die Probleme mit Festfrequenzfiltern umgangen, da die driftende Sinusfrequenz als Referenzsignal benutzt wird. Somit können einfache und damit preisgünstige Sinus-Oszillatoren eingesetzt werden. Da die phasenabhängige Gleichrichtung gleichzeitig als sehr schmalbandiger Filter arbeitet, erhält man eine hervorragende Störsignalunterdrückung.

Das von der phasenabhängigen Gleichrichteranordnung abgegebene Signal wird dann einem Analog/Digital-Wandler 12 mit Schnittstelle zugeführt, dessen Ausgangssignal schließlich über die Schnittstelle an ein Steuergerät mit Mikroprozessor bzw. an eine andere Auswerte-Elektronik geleitet werden kann.

Der in Fig. 2 dargestellte Eingangsverstärker 5 arbeitet als Differenzverstärker für einen kapazitiv induzierten Differenzstrom zwischen dessen beiden Eingangselektroden. Zur Realisierung dieses Differenzverstärkers wird vorteilhaft ein handelsüblicher Operationsverstärker 16 eingesetzt. Am invertierenden Eingang 17 des Operationsverstärkers 16 ist der Sensordraht 2 angeschlossen, während der nicht invertierende Eingang 18 mit einem zwischen der Konstantspannungsquelle 7 und dem Ausgang der Sinussignalquelle 6 angeordneten Spannungsteiler 19, 21 verbunden ist, wobei dem Widerstand 21 ein Kondensator 22 parallelgeschaltet ist. Die Abschirmelektrode 3 ist über einen Kondensator 23 mit dem Ausgang der Sinussignalquelle 6 und über einen Widerstand 24 mit Masse verbunden.

Der Operationsverstärker 16 ist außerdem mittels eines zwischen Ausgang und invertierendem Eingang 17 angeordneten Widerstandes 25 gegengekoppelt, wodurch bekanntlich der Eingangswiderstand des Verstärkers herabgesetzt und somit die Empfindlichkeit von den Eingangskapazitäten kaum beeinträchtigt wird. Die von der Konstantspannungsquelle 7 gelieferte Versorgungsspannung für den Operationsverstäker 16 ist - durch Zuführung des Sinussignals an die Quelle 7 - relativ zur Abschirmelektrode 3 stabilisiert. Somit steht die volle Empfindlichkeit der Meßschaltung zur Verfügung. Das am Ausgang des Operationsverstärkers 16 abnehmbare Signal wird, wie in Verbindung mit Fig. 1 beschrieben, entweder über die Subtrahierstufe 8 und das Filter 9 oder direkt der phasenabhängigen Gleichrichteranordnung 11 zugeführt.

## Patentansprüche

1. Meßschaltung für einen aus Sensordraht (2) und Abschirmelektrode (3) bestehenden kapazitiven Sensor (1) zur Abstandsmessung und/oder Raumüberwachung, **dadurch gekennzeichnet, daß** die Abschirmelektrode (3) mit einem Sinussignal beaufschlagt ist, daß der Sensordraht (2) über ein abgeschirmtes Kabel (4) mit dem einen Eingang eines als Strom-Spannungs-Wandler dienenden Eingangsverstärkers (5) verbunden ist, dessen Versorgungsspannung ebenfalls vom Sinussignal beeinflußt ist, daß der Ausgang des Eingangsverstärkers (5) mit dem einen Eingang einer phasenabhängigen Gleichrichteranordnung (11) verbunden ist, an deren anderem Eingang das Sinussignal anliegt und deren Ausgang an einen Analog/Digital-Wandler (12) angeschlossen ist.

2. Meßschaltung nach Anspruch 1, **dadurch gekennzeichnet, daß** der Eingangsverstärker (5) ein gegengekoppelter Differenzverstärker für einen kapazitiv induzierten Differenzstrom ist, dessen invertierender Eingang (17) mit dem Sensordraht (2) verbunden ist und dessen nicht invertierender Eingang (18) an einen zwischen einer Konstantspannungsquelle (7) und der Sinussignalquelle (6) geschalteten Spannungsteiler (19, 21) angeschlossen ist, wobei der mit der Sinussignalquelle (6) verbundene Widerstand (21) des Spannungsteilers mit einem Kondensator (22) überbrückt ist.

3. Meßschaltung nach Anspruch 2, **dadurch gekennzeichnet, daß** als Differenzverstärker ein Operationsverstärker (16) eingesetzt ist, dessen Versorgungsspannung durch einen Spannungsregler relativ zur Spannung der Abschirmelektrode stabilisiert ist.

4. Meßschaltung nach Anspruch 2, **dadurch gekennzeichnet, daß** die Abschirmelektrode (3) des Sensors (1) über die Abschirmung des abgeschirmten Kabels (4) mit der Sinussignalquelle (6) verbunden ist.

5. Meßschaltung nach Anspruch 1, **dadurch gekennzeichnet, daß** zwischen Eingangsverstärker (5) und phasenabhängiger Gleichrichteranordnung (11) eine Subtrahierstufe (8) vorgesehen ist, deren positiver Eingang mit dem Ausgang des Eingangsverstärkers (5) verbunden ist und deren negativer Eingang mit dem Sinussignal beaufschlagt ist.

6. Meßschaltung nach Anspruch 5, **dadurch gekennzeichnet, daß** am Ausgang der Subtrahierstufe (8) ein Filter (9) vorgesehen ist.

## Claims

1. Measuring circuit for a capacitive sensor (1), composed of sensor wire (2) and screening electrode (3), for measuring distances and/or monitoring space, **characterized in that in that** a sinusoidal signal is applied to the screening electrode (3), **in that** the sensor wire (2) is connected via a screened cable (4) to one of the inputs of an input amplifier (5) which is used as a current/voltage transformer and whose supply voltage is also influenced by the sinusoidal signal, **in that** the output of the input amplifier (5) is connected to one of the inputs of a phase-dependent rectifier arrangement (11) at whose other input the sinusoidal signal is present and whose output is connected to an analogue/digital converter (12).

2. Measuring circuit according to Claim 1, **characterized in that** the input amplifier (5) is a negatively fed-back difference amplifier for a capacitively induced difference current whose inverting input (17) is connected to the sensor wire (2) and whose non-inverting input (18) is connected to a voltage divider (19, 21) which is connected between a constant voltage source (7) and the sinusoidal signal source (6), the resistor (21), connected to the sinusoidal signal source (6), of the voltage divider being shorted- out by means of a capacitor (22).

3. Measuring circuit according to Claim 2, **characterized in that** an operational amplifier (16) whose supply voltage is stabilized by a voltage regulator in relation to the voltage of the screening electrode is used as the difference amplifier.

4. Measuring circuit according to Claim 2, **characterized in that** the screening electrode (3) of the sensor (1) is connected to the sinuzoidal signal source (6) via the screening of the screened cable (4).

5. Measuring circuit according to Claim 1, **characterized in that** a subtractor stage (8) whose positive input is connected to the output of the input amplifier (5) and to whose negative input the sinuzoidal signal is applied is provided between the input amplifier (5) and phase-dependent rectifier arrangement (11).

6. Measuring circuit according to Claim 5, **characterized in that in that** a filter (9) is provided at the output of the subtractor stage (8).

## Revendications

1. Circuit de mesure pour un capteur capacitif (1) formé d'un fil de capteur (2) et d'une électrode de blindage (3), pour une mesure de distance et/ou une surveillance de volume,
**caractérisé en ce que**
l'électrode formant blindage (3) reçoit un signal sinusoïdal,
le fil de capteur (2) est relié par un câble blindé (4) à une entrée d'un amplificateur d'entrée (5) servant de convertisseur courant-tension et dont la tension d'alimentation est également influencée par le signal sinusoïdal, et
la sortie de l'amplificateur d'entrée (5) est reliée à une entrée d'un redresseur (11) dépendant de la phase et dont l'autre entrée reçoit le signal sinusoïdal, sa sortie étant reliée à un convertisseur analogique/numérique (12).

2. Circuit de mesure selon la revendication 1,
**caractérisé en ce que**
l'amplificateur d'entrée (5) est un amplificateur de différence couplé en réaction pour un courant de différence induit de manière capacitive, l'entrée inversée (17) étant reliée au fil de capteur (2) et l'entrée non inversée (18) étant reliée à un diviseur de tension (19, 21) branché entre une source de tension constante (7) et la source de signal sinusoïdal (6), la résistance (21) du diviseur de tension, reliée à la source de signal sinusoïdal (6), étant court-circuitée par un condensateur (22).

3. Circuit de mesure selon la revendication 2,
**caractérisé en ce que**
l'amplificateur de différence est un amplificateur opérationnel (16) dont la tension d'alimentation est stabilisée par un régulateur de tension par rapport à la tension de l'électrode blindée.

4. Circuit de mesure selon la revendication 2,
**caractérisé en ce que**
l'électrode blindée (3) du capteur (1) est reliée par le blindage du câble blindé (4) à la source de signal sinusoïdal (6).

5. Circuit de mesure selon la revendication 1,
**caractérisé par**
un étage soustracteur (8) entre l'amplificateur d'entrée (5) et le redresseur (11) dépendant de la phase, l'entrée positive de l'étage soustracteur étant reliée à la sortie de l'amplificateur d'entrée (5) et son entrée négative recevant le signal sinusoïdal.

6. Circuit de mesure selon la revendication 5,
**caractérisé en ce que**
la sortie de l'étage soustracteur (8) est équipée d'un filtre (9).
